# EUROPEAN PATENT APPLICATION

(11) **EP 4 734 669 A1**
(43) Date of publication of application: **29.04.2026**
(21) Application number: 25209342.2
(22) Date of filing: 17.10.2025
(51) Int. Cl.: H05K 1/02, G09F 9/30, H10H 20/85, H05K 1/189, H05K 3/00

(54) **METHOD OF MANUFACTURING CIRCUIT BOARD**

(30) Priority: 22.10.2024 JP 2024186060
(71) Applicant: Alps Alpine Co., Ltd., Ota-ku, Tokyo 145-8501 (JP)
(72) Inventor: Kishida, Katsuhiko, Iwaki-city Fukushima (JP)
(74) Representative: Schmitt-Nilson Schraud Waibel Wohlfrom Patentanwälte Partnerschaft mbB

(57) **Abstract**

A method of manufacturing a circuit board is disclosed. The method includes: a first step of forming a plurality of pixel circuits on a film with the pixels connected to each other by a wiring pattern; a second step of processing the film to thin the film at least at a position between pixels, and singulating the film into individual pixel units such that the film is cut together with the wiring pattern at the position between the pixels; a third step of transferring a plurality of singulated pieces, each having a pixel circuit formed thereon, onto a flexible substrate; and a fourth step of forming a stretchable interconnect by depositing liquid metal between wiring patterns cut in the second step.

## Description

The present disclosure relates to a method of manufacturing a circuit board.

In recent years, the development of flexible devices capable of bending or stretching deformation has been widely pursued. As an example of a circuit board used in flexible devices, a circuit board is known that includes a base member having stretchability or flexibility, a conductive layer including a predetermined pattern and liquid metal formed on the base member, and a coating layer laminated on the conductive layer (see, for example, JP7509980B).

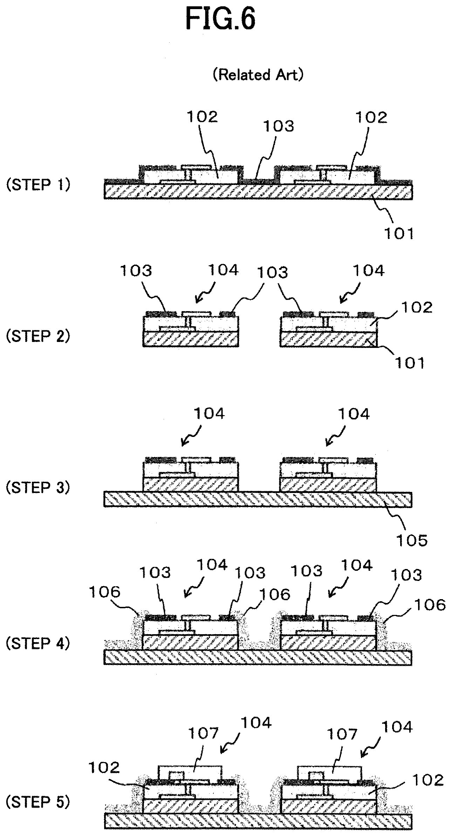

For example, a circuit board for a stretchable film display using micro LEDs is manufactured by the process illustrated in FIG. 6. First, a plurality of pixel circuits 102 are formed on a film 101 (step 1). For the film 101, for example, a polyimide film (hereinafter referred to as a PI film 101) is used. At this stage, the plurality of pixel circuits 102 formed on the PI film 101 are connected between pixels by a metal wiring pattern 103.

Next, the PI film 101 is singulated into pixel units by cutting the PI film 101 together with the wiring pattern 103 at a position between pixels (step 2), and then each singulated piece 104 is transferred onto a rubber substrate 105 having stretchability and flexibility (step 3). Thereafter, stretchable interconnects are formed by depositing liquid metal 106 at a position between the wiring patterns 103 of respective singulated pieces 104 (step 4). Finally, micro LEDs 107 are mounted on the pixel circuits 102 of respective singulated pieces 104 (step 5).

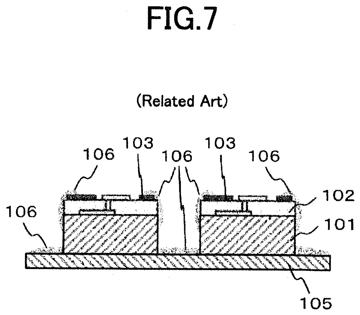

In step 4, to connect the singulated pieces 104 with the liquid metal 106, it is necessary to keep the height difference between the wiring patterns 103 formed on the pixel circuits 102 of the singulated pieces 104 and the rubber substrate 105 below a predetermined value. If this height difference is large, as illustrated in FIG. 7, the wiring patterns 103 of the pixel circuits 102 in the singulated pieces 104 cannot be connected by the liquid metal 106 due to factors such as the surface tension of the liquid metal 106.

Using a thin PI film 101 can reduce the height difference. However, when step 1 is performed using a Roll-to-Roll processing method for purposes such as cost reduction and improved productivity, it is difficult to make the thickness of the PI film 101 less than the predetermined value. If the PI film 101 thicker than the predetermined value is used in the processes from step 1 to step 3, increasing the amount of liquid metal 106 introduced in step 4 would allow the wiring patterns 103 of the singulated pieces 104 to be connected by the liquid metal 106. However, this causes a problem in that the liquid metal 106 overflows to unnecessary positions on the pixel circuits 102, leading to short circuits in the circuit.

The present disclosure relates to a method of manufacturing a circuit board according to the appended claims. Embodiments are disclosed in the dependent claims.

According to an aspect of the present disclosure, a method of manufacturing a circuit board is provided, The method includes:
a first step of forming a plurality of pixel circuits on a film with the pixels connected to each other by a wiring pattern;
a second step of processing the film to thin the film at least at a position between pixels, and singulating the film into individual pixel units such that the film is cut together with the wiring pattern at the position between the pixels;
a third step of transferring a plurality of singulated pieces, each having a pixel circuit formed thereon, onto a flexible substrate; and
a fourth step of forming a stretchable interconnect by depositing liquid metal between wiring patterns cut in the second step.

Other objects and further features of the present invention will be apparent from the following detailed description when read in conjunction with the accompanying drawings, in which:
FIG. 1A is a process diagram illustrating a method of manufacturing a circuit board according to a first embodiment;
FIG. 1B is a process diagram illustrating a method of manufacturing a circuit board according to the first embodiment;
FIG. 2A is a process diagram illustrating a method of manufacturing a circuit board according to a second embodiment;
FIG. 2B is a process diagram illustrating a method of manufacturing a circuit board according to the second embodiment;
FIG. 3 is a process diagram illustrating a method of manufacturing a circuit board according to a first modification of the second embodiment;
FIG. 4 is a process diagram illustrating a method of manufacturing a circuit board according to a second modification of the second embodiment;
FIG. 5A is a process diagram illustrating a method of manufacturing a circuit board according to a third embodiment;
FIG. 5B is a process diagram illustrating a method of manufacturing a circuit board according to the third embodiment;
FIG. 6 is a process diagram illustrating a conventional method of manufacturing a circuit board; and
FIG. 7 is a diagram illustrating conventional issues.

The present disclosure is directed to enabling appropriate connection between wiring patterns of respective pixel circuits with a suitable amount of liquid metal, while forming a plurality of pixel circuits using a film having a thickness equal to or greater than a predetermined value.

According to an aspect of the present disclosure described above, in the second step, the film is processed such that the film is thinned at least at the position where the wiring pattern is formed between pixels, and the film is singulated into pixel units by cutting the film together with the wiring pattern at this position. As a result, in the region in which the liquid metal is deposited between the pixels, the height difference can be made less than a predetermined value, even when the film with a thickness equal to or greater than the predetermined value is used to form a plurality of pixel circuits in the first step, thereby allowing the wiring patterns of respective pixel circuits to be appropriately connected with an appropriate amount of liquid metal.

In the following, embodiments of the present invention will be described with reference to the accompanying drawings. In the specification and drawings, elements having substantially the same functions or configurations are denoted with the same numerals, and duplicate description thereof is omitted.

### (First Embodiment)

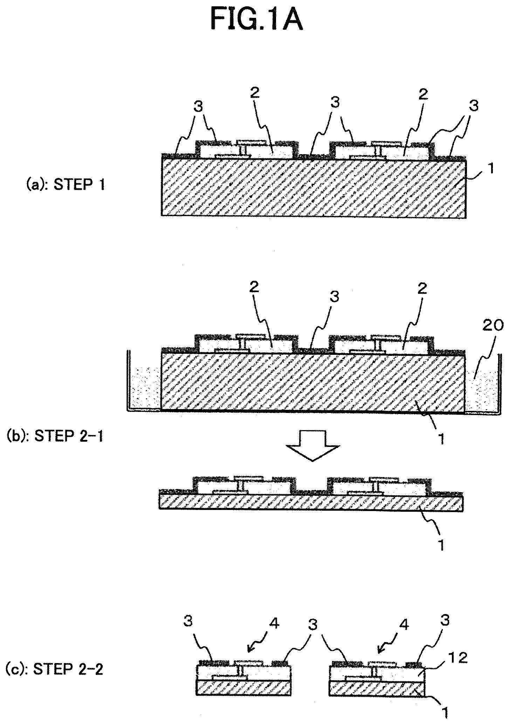

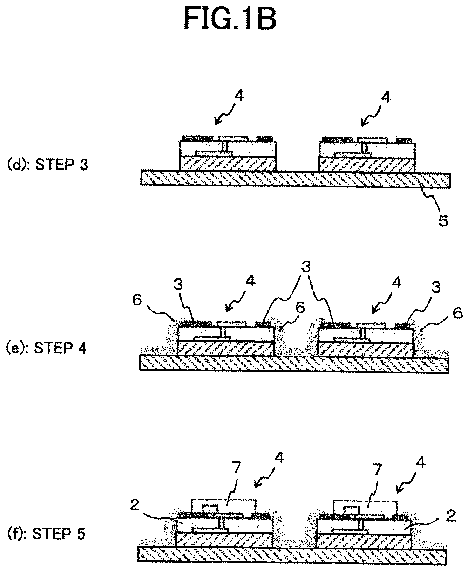

A first embodiment will be described below with reference to the drawings. FIGS. 1A and 1B are process diagrams illustrating a method of manufacturing a circuit board according to the first embodiment. FIGS. 1A and 1B illustrate a manufacturing process of a circuit board for a stretchable film display using micro LEDs, illustrating a partial side cross-sectional view of the circuit board.

First, as illustrated in (a) of FIG. 1A, a plurality of pixel circuits 2 are formed on a film 1 in a state in which the pixel circuits are connected each other by a metal wiring pattern 3 (step 1). The state in which the pixel circuits are connected each other by the wiring pattern 3 refers to a state in which the wiring pattern 3 extends from a surface of one pixel circuit 2, across its side surface, and over the film 1 between the pixel circuits to reach an adjacent pixel circuit 2. Note that, although only two pixel circuits 2 are illustrated in FIG. 1A and FIG. 1B, in practice, a larger number of pixel circuits 2 are arranged on the film 1 (the same applies to each of the figures illustrated below).

For the film 1, for example, a polyimide film (hereinafter referred to as the PI film 1) is used, but the film is not limited to the PI film. In this step 1, a plurality of pixel circuits 2 are formed on the PI film 1 using a Roll-to-Roll processing method for purposes such as cost reduction and improved productivity. Accordingly, the PI film 1 has a sufficient thickness required for Roll-to-Roll processing method. For example, the thickness of the PI film 1 is 80 µm. This thickness is such that, if the PI film 1 were singulated as is, the height difference would be too large, as illustrated in FIG. 7, making it difficult to connect the pixel circuits 2 with liquid metal. For illustrative purposes, the pixel circuits 2 are depicted with a visible thickness, but in practice, their thickness is 1 µm or less.

The plurality of pixel circuits 2 formed on the PI film 1 may be arranged linearly in a single row or may be arranged in a matrix in a first direction (row direction) and a second direction (column direction) orthogonal to the first direction. When the plurality of pixel circuits 2 are arranged in a matrix, the pixel circuits 2 aligned in the first direction are connected by the wiring pattern 3 for a first wiring, and the pixel circuits 2 aligned in the second direction are connected by the wiring pattern 3 for a second wiring. Alternatively, the pixel circuits may be connected by the wiring pattern 3 in only one of the first direction or the second direction.

Next, as illustrated in (b) and (c) of FIG. 1A, the PI film 1 is processed such that the thickness of the entire processing region of the PI film 1 is reduced, and the PI film 1 is singulated into pixel units such that the PI film 1 is cut together with the wiring pattern 3 at a position between pixels (step 2). The processing region refers to a region in which a plurality of pixel circuits 2 are present. In the first embodiment, the step 2 includes an etching step (step 2-1) illustrated in (b) of FIG. 1A and a cutting step (step 2-2) illustrated in (c) of FIG. 1A.

As illustrated in (b) of FIG. 1A, in the etching step (step 2-1), the entire processing region of the PI film 1 is thinned by immersing, in an etching solution 20, a partial thickness region of the PI film 1 from a surface opposite to the surface on which the pixel circuits 2 are formed (hereinafter sometimes referred to as the "back surface"), the surface on which the pixel circuits 2 are formed being hereinafter sometimes referred to as the "front surface." As a result, the thickness of the etched PI film 1 is made less than a predetermined value. The thickness less than the predetermined value refers to a thickness at which the wiring patterns 3 of the pixel circuits 2 can be appropriately connected with an appropriate amount of liquid metal without causing a short circuit of the circuits. For example, the thickness of the PI film 1 may be set to 30 to 5 µm by etching.

As illustrated in (c) of FIG. 1A, in the cutting step (step 2-2) following the etching step, the etched PI film 1 is cut together with the wiring pattern 3 at a position between pixels to singulate the PI film 1 into pixel units. Here, the PI film 1 is cut together with the wiring pattern 3 in such a manner that a portion of the wiring pattern 3 formed on the surface of the pixel circuits 2 is retained, while a portion of the wiring pattern 3 connecting between the pixel circuits 2 is not retained.

Next, as illustrated in (d) of FIG. 1B, a plurality of singulated pieces 4, each having a pixel circuit 2 formed on the cut PI film 1, are transferred onto a flexible substrate 5 (step 3). In the following description, the term "singulated piece 4" refers to a structure in which a pixel circuit 2 is formed on the cut PI film 1. The flexible substrate 5 may be any material having stretchability and/or flexibility, and may be, for example, a rubber substrate. In this step, the plurality of singulated pieces 4 are transferred onto the flexible substrate 5 in a manner that a positional relationship between pixels are maintained when the plurality of pixel circuits 2 are formed on the PI film 1 in step 1.

Next, as illustrated in (e) of FIG. 1B, stretchable interconnects are formed by depositing liquid metal 6 between the wiring patterns 3 cut in step 2-2 (step 4). In the state in which the plurality of singulated pieces 4 are transferred onto the flexible substrate 5, a height difference between the wiring patterns 3 formed on the pixel circuits 2 and the flexible substrate 5 is less than a predetermined value. This allows the wiring patterns 3 of respective pixel circuits 2 to be appropriately connected with an appropriate amount of liquid metal 6.

Finally, as illustrated in (f) of FIG. 1B, micro LEDs 7 are mounted on the pixel circuits 2 of singulated pieces 4, respectively (step 5). This completes the circuit board for a stretchable film display using micro LEDs 7.

As described above, according to the first embodiment, in step 2, the PI film 1 is thinned by etching, and the PI film 1 is cut together with the wiring patterns 3 at a position between pixels to form singulated pieces 4 in pixel units. As a result, in the region in which the liquid metal 6 is applied between pixels, the height difference between the wiring patterns 3 formed on the pixel circuits 2 and the flexible substrate 5 can be made less than the predetermined value, thereby avoiding a state in which the wiring patterns 3 are not connected by the liquid metal 6. Thus, while forming a plurality of pixel circuits 2 using a PI film 1 with a thickness equal to or greater than the predetermined value to in step 1, the wiring patterns 3 of respective pixel circuits 2 can be appropriately connected with an appropriate amount of liquid metal 6.

### (Second Embodiment)

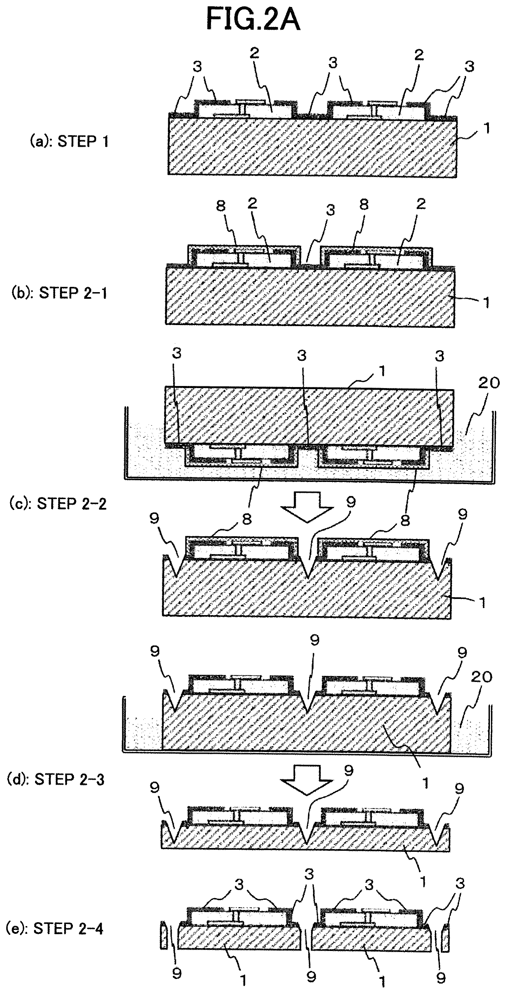

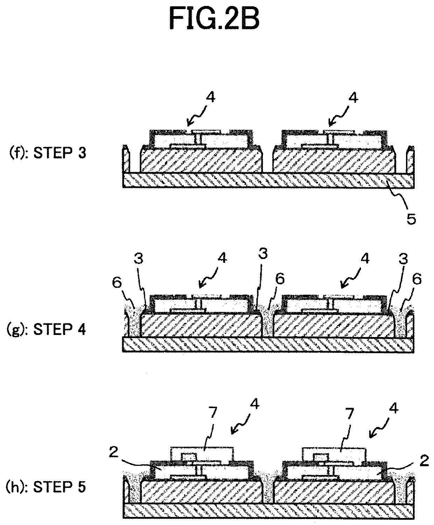

Next, a second embodiment will be described with reference to the drawings. FIGS. 2A and 2B are process diagrams illustrating a method of manufacturing a circuit board according to the second embodiment. FIGS. 2A and 2B illustrate the manufacturing process of a circuit board for a stretchable film display using micro LEDs 7, illustrating partial side cross-sectional views of the circuit board.

First, as illustrated in (a) of FIG. 2A, a plurality of pixel circuits 2 are formed on a film 1 in a state in which the pixels are connected to each other by a metal wiring pattern 3 (step 1). This step 1 is the same as that in the first embodiment.

After the step 1, as illustrated in (b) to (e) of FIG. 2, the PI film 1 is processed such that the thickness at a position between pixels and the thickness of the entire processing region are reduced, and the PI film 1 is singulated into pixel units such that the PI film 1 is cut together with the wiring pattern 3 at a position between pixels (step 2). In the second embodiment, the step 2 (second step) includes a masking step (step 2-1) illustrated in (b) of FIG. 2A, a first etching step (step 2-2) illustrated in (c) of FIG. 2A, a second etching step (step 2-3) illustrated in (d) of FIG. 2A, and a cutting step (step 2-4) illustrated in (e) of FIG. 2A.

As illustrated in (b) of FIG. 2A, in the masking step (step 2-1), a resist 8 is applied to regions other than a non-masked region. The non-masked region includes at least a portion of a region in which the wiring pattern 3 is formed between pixels. The non-masked region, which is excluded from the resist application, is a region in which the liquid metal 6 will be applied and includes a portion of the region in which the wiring pattern 3 is formed between pixels, optionally includes some of the surrounding PI film 1. In contrast, the regions in which the resist 8 is applied includes surfaces and sides of the pixel circuits 2 and regions of the PI film 1 in which neither the pixel circuits 2 nor the wiring pattern 3 is formed.

In the subsequent first etching step (step 2-2), as illustrated in (c) of FIG. 2A, by immersing a portion of the PI film 1 from the surface on which the pixel circuits 2 are formed up to a predetermined thickness of the PI film 1 into the etching solution 20, the non-masked region, where the resist 8 is not applied, is partially thinned. When etching the non-masked region in which the wiring pattern 3 is formed between pixels, as illustrated in (c) of FIG. 2A, the wiring patterns 3 not covered with the resist 8 are first removed, and then the PI film 1 is gradually removed. At this time, due to the influence of portions of the wiring pattern protected by the resist, the deeper the position from the surface of the PI film 1, the less material is removed, resulting in an inclined surface being formed in the etched region 9 of the PI film 1.

Partially thinning the non-masked region of the PI film 1 in which the wiring pattern 3 is formed between pixels means creating an etched region 9 with an inclined surface. The purpose of the first etching step is to form an inclined surface in the etched region 9 in the regions in which the liquid metal 6 will be applied. Therefore, the predetermined thickness of the PI film 1 immersed in the etching solution 20 to form this etched region 9; that is, the depth of the etched region 9 to be removed, is not particularly limited, and may be less than or equal to or greater than the predetermined value described in the first embodiment. In this embodiment, the depth of the etched region 9 is set to be less than the predetermined value.

In the subsequent second etching step (step 2-3), as illustrated in (d) of FIG. 2A, after removing the resist 8, a partial thickness region of the PI film 1 from the back surface opposite to the surface on which the pixel circuits 2 are formed is immersed in the etching solution 20, thereby thinning the entire processing region of the PI film 1. As a result, the thickness of the etched PI film 1 is made less than a predetermined value such that the wiring patterns 3 of the pixel circuits 2 can be connected with an appropriate amount of liquid metal 6. In this embodiment, the thickness of the PI film 1 partially removed in the first etching step (the depth of the etched region 9) is less than the thickness of the PI film 1 etched in the second etching step (post-etching thickness).

In the subsequent cutting step (step 2-4), as illustrated in (e) of FIG. 2A, the etched PI film 1 is cut at a position between pixels to singulate the PI film 1 into pixel units. In this step, the PI film 1 is cut at the position of the etched region 9 in such a manner that all portions of the wiring pattern 3 that has not been removed by etching (i.e., the wiring pattern 3 formed on the surface and sides of the pixel circuits 2 and portions on the PI film 1) are retained. That is, the PI film 1 is cut at an intermediate position along the inclined surface of the etched region 9.

Next, as illustrated in (f) of FIG. 2B, a plurality of singulated pieces 4, each having a pixel circuit 2 formed on the cut PI film 1, are transferred onto a flexible substrate 5 (step 3). This step 3 is the same as that in the first embodiment.

Next, as illustrated in (g) of FIG. 2B, stretchable interconnects are formed by depositing liquid metal 6 between the wiring patterns 3 cut in step 2-4 (step 4). In the second embodiment, the cut wiring patterns 3 remains on portions of the cut PI films 1, and the liquid metal 6 is applied so as to connect the wiring patterns 3 of these portions. In this respect, the second embodiment differs from the first embodiment in which the liquid metal 6 is applied to connect the wiring patterns 3 formed on the pixel circuits 2. Here, the height difference between the wiring pattern 3 remaining on a portion of the PI film 1 and the flexible substrate 5 is less than a predetermined value. As a result, the wiring patterns 3 of respective pixel circuits 2 can be appropriately connected with an appropriate amount of liquid metal 6.

Additionally, a portion of the wiring pattern 3 remaining on the PI film 1 has an inclined surface of the etched region 9. In the second embodiment, the application of the liquid metal 6 to this inclined surface differs from the first embodiment in which the liquid metal 6 is applied to a 90-degree corner portion without an inclined surface. By depositing the liquid metal 6 to the inclined surface, sufficient thickness of the liquid metal 6 can be maintained at the inclined surface portion, thereby reducing the risk of disconnection caused by thinning of the liquid metal 6 at the corner portions.

Finally, as illustrated in (h) of FIG. 2B, micro LEDs 7 are mounted on the pixel circuits 2 of respective singulated pieces 4 (step 5). This completes the circuit board for a stretchable film display using micro LEDs 7.

As described above, according to the second embodiment, in step 2, after forming the etched region 9 with an inclined surface on the surface of the PI film 1, the entire processing region of the PI film 1 is thinned by etching, and the PI film 1 is cut at a position between pixels to form singulated pieces 4 in pixel units. As a result, in the region in which the liquid metal 6 is applied between pixels, the height difference between the wiring patterns 3 formed on the pixel circuits 2 and the flexible substrate 5 can be made less than a predetermined value. Thus, while using a PI film 1 with a thickness equal to or greater than a predetermined value to form a plurality of pixel circuits 2 in step 1, the wiring patterns 3 of respective pixel circuits 2 can be appropriately connected with an appropriate amount of liquid metal 6. Additionally, depositing the liquid metal 6 to the inclined surface reduces the risk of disconnection caused by thinning the liquid metal 6.

### (First Modification)

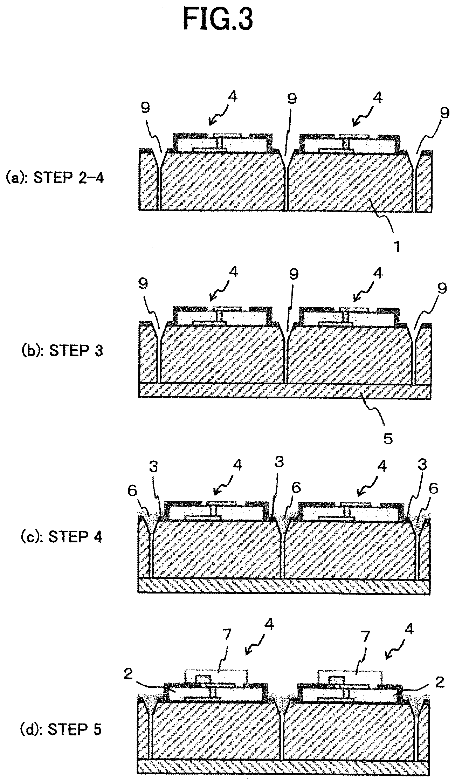

In the second embodiment described above, the second etching step (step 2-3) may be omitted. In this case, the process steps performed after the first etching step (step 2-2) are as illustrated in FIG. 3. FIG. 3 is a process diagram illustrating a method of manufacturing a circuit board according to a first modification of the second embodiment.

As illustrated in (a) of FIG. 3, in the cutting step (step 2-4) following the etching step (step 2-2) illustrated in (c) of FIG. 2A, the PI film 1 is cut at an intermediate position along the inclined surface of the etched region 9 to singulate the PI film 1 into pixel units. Here, the PI film 1 is cut at a position where the side end surfaces of adjacent singulated pieces 4 are closer to each other compared to the cutting position illustrated in (e) of FIG. 2A.

Next, as illustrated in (b) of FIG. 3, a plurality of singulated pieces 4, each having a pixel circuit 2 formed on the cut PI film 1, are transferred onto a flexible substrate 5 (step 3). The step 3 of the first modification is the same as that in the second embodiment described above.

Next, as illustrated in (c) of FIG. 3, stretchable interconnects are formed by depositing liquid metal 6 between the wiring patterns 3 cut in step 2-4 illustrated in (a) of FIG. 3 (step 4). The application of the liquid metal 6 to connect the wiring patterns 3 remaining on portions of the PI film 1 and introducing the liquid metal 6 into the etched region 9 in the first modification are the same as in the second embodiment described above for the first modification.

In the case of the first modification illustrated in FIG. 3, the height difference between the wiring pattern 3 remaining on a portion of the PI film 1 and the flexible substrate 5 is equal to or greater than a predetermined value. However, since the side end surfaces of adjacent singulated pieces 4 are close to each other, the liquid metal 6 adheres across a narrow gap between the singulated pieces 4 due to the viscosity or surface tension of the liquid metal 6. Since the height difference between the wiring pattern 3 and an upper end surface of the narrow gap is less than a predetermined value, it is possible to appropriately connect the wiring patterns 3 of respective pixel circuits 2 with an appropriate amount of liquid metal 6.

Finally, as illustrated in (d) of FIG. 3, micro LEDs 7 are mounted on the pixel circuits 2 of respective singulated pieces 4 (step 5). The step 5 of the first modification is the same as that in the second embodiment described above. This completes the circuit board for a stretchable film display using micro LEDs 7.

### (Second Modification)

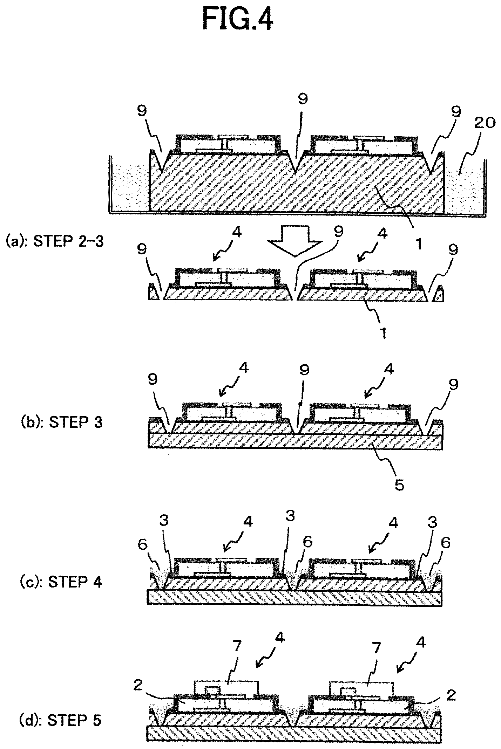

In the second embodiment described above, an example in which the depth of the etched region 9 is less than a predetermined value has been described; however, as noted above, the depth may also be equal to or greater than the predetermined value. In the second embodiment, an example has been described in which the depth of the etched region 9 is less than the thickness of the PI film 1 etched in the second etching step, but it may also be made greater than thickness. Accordingly, the cutting step (step 2-4) illustrated in (e) of FIG. 2A may be omitted. FIG. 4 is a process diagram illustrating the method of manufacturing a circuit board in this case.

In the second modification illustrated in FIG. 4, the first etching step (step 2-2) is the same as that in the second embodiment illustrated in (c) of FIG. 2A, but the etched region 9 may be formed deeper. As illustrated in (a) of FIG. 4, in the second etching step (step 2-3), by immersing, in an etching solution 20, a thickness region of the PI film 1 from the back surface opposite to the surface on which the pixel circuits 2 are formed, up to the bottom surface of the etched region 9 partially thinned in the first etching step, the entire processing region of the PI film 1 is thinned and the PI film 1 is separated at a position between pixels, thereby singulating the PI film 1 into pixel units. Since this etching forms the singulated pieces 4, the cutting step (step 2-4) illustrated in (e) of FIG. 2A is unnecessary.

Next, as illustrated in (b) of FIG. 4, the plurality of singulated pieces 4 formed in the second etching step are transferred onto a flexible substrate 5 (step 3). The step 3 of the second modification is the same as that in the second embodiment described above. Next, as illustrated in (c) of FIG. 4, stretchable interconnects are formed by depositing liquid metal 6 between the wiring patterns 3 cut in the second etching step (step 4). The application of the liquid metal 6 to connect the wiring patterns 3 remaining on portions of the cut PI films 1 and introducing the liquid metal 6 into the etched region 9 are the same as in the second embodiment described above.

In the second modification illustrated in FIG. 4, since the height difference between the wiring pattern 3 remaining on a portion of the PI film 1 and the flexible substrate 5 is less than a predetermined value, the wiring patterns 3 of respective pixel circuits 2 can be appropriately connected with an appropriate amount of liquid metal 6. Finally, as illustrated in (d) of FIG. 4, micro LEDs 7 are mounted on the pixel circuits 2 of respective singulated pieces 4 (step 5). The step 5 of the second modification is the same as that in the second embodiment described above. This completes the circuit board for a stretchable film display using micro LEDs 7.

### (Third Embodiment)

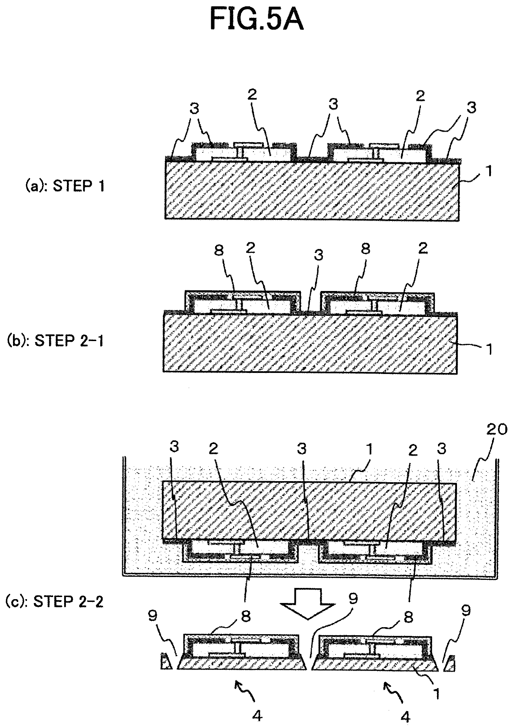

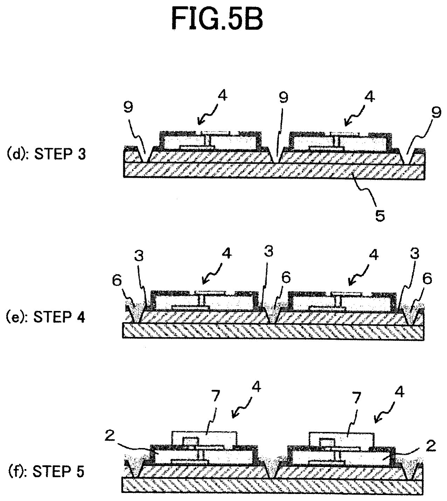

Next, a third embodiment will be described with reference to the drawings. FIGS. 5A and 5B are process diagrams illustrating a method of manufacturing a circuit board according to the third embodiment. FIGS. 5A and 5B illustrate the manufacturing process of a circuit board for a stretchable film display using micro LEDs 7, illustrating a partial side cross-sectional view of the circuit board.

First, as illustrated in (a) of FIG. 5A, a plurality of pixel circuits 2 are formed on a film 1 in a state in which the pixels are connected to each other by a metal wiring pattern 3 (step 1). This step 1 is the same as that in the second embodiment.

After step 1, as illustrated in (b) and (c) of FIG. 2A, the PI film 1 is processed such that the thickness at a position between pixels and the thickness of the entire processing region are reduced, and the PI film 1 is singulated into pixel units such that the PI film 1 is cut together with the wiring pattern 3 at a position between pixels (step 2). In the third embodiment, the step 2 includes a masking step (step 2-1) illustrated in (b) of FIG. 5A and an etching step (step 2-2) illustrated in (c) of FIG. 5A.

As illustrated in (b) of FIG. 5A, in the masking step (step 2-1), a resist 8 is applied to regions other than a non-masked region. The non-masked region includes at least a portion of a region in which the wiring pattern 3 is formed between pixels. This masking step is the same as that in the second embodiment.

In the subsequent etching step (step 2-2), as illustrated in (c) of FIG. 5A, the entirety of the PI film 1, the pixel circuits 2, the wiring pattern 3 between pixels, and the resist 8 are immersed in an etching solution 20, thereby partially thinning the non-masked region from the surface of the PI film 1 on which the pixel circuits 2 are formed, while simultaneously thinning the entire processing region of the PI film 1 from the back surface opposite to the surface on which the pixel circuits 2 are formed, and separating the PI film 1 at a position between pixels to singulate the PI film 1 into pixel units.

The etching step illustrated in (c) of FIG. 5A corresponds to simultaneously performing the first etching step from the surface of the PI film 1 illustrated in (c) of FIG. 2A and the second etching step from the back surface of the PI film 1 illustrated in (a) of FIG. 4. In order to form the etched region 9 in the state illustrated in (c) of FIG. 5A by this etching, the temperature of the etching solution 20 and the etching time are appropriately controlled.

After the etching step, the resist 8 is removed, and the processes illustrated in FIG. 5B are performed. The step 3 to step 5 illustrated in FIG. 5B are the same as those in the second embodiment.

According to the third embodiment described above, the formation of the etched region 9, the thinning of the PI film 1, and the formation of the singulated pieces 4 can be performed simultaneously in a single etching step, thereby significantly reducing the number of process steps.

It should be noted that the embodiments and modifications described above are merely examples of implementing the present disclosure, and the technical scope of the present disclosure should not be construed as being limited by these examples. That is, the present disclosure can be implemented in various forms.

For example, in the embodiments and modifications described above, step 4 and step 5 may be performed in reverse order.

Additionally, while the embodiments and modifications described above have explained examples of manufacturing a circuit board for a stretchable film display using micro LEDs 7, the invention is not limited to examples involving the mounting of micro LEDs 7. For example, mini LEDs may be mounted instead.

Although the present invention has been described with reference to embodiments, the present invention is not limited to the configurations and elements described in the embodiments, and the configurations and the elements described in the embodiments may be combined with other configurations and elements, and the above-described embodiments can be changed as appropriate without departing from the scope of the claims.

## Claims

1. A method of manufacturing a circuit board, the method comprising:
a first step of forming a plurality of pixel circuits on a film with the pixels connected to each other by a wiring pattern;
a second step of processing the film to thin the film at least at a position between pixels, and singulating the film into individual pixel units such that the film is cut together with the wiring pattern at the position between the pixels;
a third step of transferring a plurality of singulated pieces, each having a pixel circuit formed thereon, onto a flexible substrate; and
a fourth step of forming a stretchable interconnect by depositing liquid metal between wiring patterns cut in the second step.

2. The method according to claim 1, wherein the second step comprises:
an etching step of thinning the film by immersing a partial thickness region of the film in an etching solution from a back surface opposite to a surface of the film on which the pixel circuits are formed; and
a cutting step of singulating the etched film into pixel units by cutting the etched film together with the wiring pattern at the position between the pixels.

3. The method according to claim 1, wherein the second step comprises:
a masking step of applying a resist to regions other than a non-masked region, the non-masked region including at least a portion of a region in which the wiring pattern is formed between the pixels;
an etching step of partially thinning the non-masked region by immersing, in an etching solution, a portion of the film from a surface of the film on which the pixel circuits are formed up to a predetermined thickness of the film; and
a cutting step of singulating the etched film into pixel units by cutting the etched film at the position between the pixels.

4. The method according to claim 3, wherein the etching step is a first etching step; and wherein the method further comprises:
a second etching step of thinning the film by immersing, in an etching solution, a partial thickness region of the film from a back surface opposite to the surface of the film on which the pixel circuits are formed, the second etching step being performed between the first etching step and the cutting step.

5. The method according to claim 1, wherein the second step comprises:
a masking step of applying a resist to regions other than a non-masked region, the non-masked region including at least a portion of a region in which the wiring pattern is formed between the pixels;
a first etching step of partially thinning the non-masked region by immersing, in an etching solution, a portion of the film from a surface of the film on which the pixel circuits are formed up to a predetermined thickness of the film; and
a second etching step of thinning the film and separating the film at the position between the pixels so as to singulate the film into pixel units by immersing, in an etching solution, a thickness region of the film from a back surface opposite to the surface of the film on which the pixel circuits are formed up to a bottom surface of the region partially thinned in the first etching step.

6. The method according to claim 1, wherein the second step comprises:
a masking step of applying a resist to regions other than a non-masked region, the non-masked region including at least a portion of a region in which the wiring pattern is formed between the pixels; and
an etching step of immersing, in an etching solution, an entirety of the film, including the pixel circuits, the wiring pattern between the pixels, and the resist to partially thin the non-masked region from a surface of the film on which the pixel circuits are formed, while simultaneously thinning the film from a back surface opposite to the surface of the film on which the pixel circuits are formed, and separating the film at the position between the pixels to singulate the film into pixel units.
